# EUROPÄISCHE PATENTSCHRIFT

(11) **EP 1 170 600 B1**
(45) Veröffentlichungstag und Bekanntmachung des Hinweises auf die Patenterteilung: **02.11.2006**
(21) Anmeldenummer: 01114374.0
(22) Anmeldetag: 13.06.2001
(51) Int. Cl.: G01V 8/12, G01V 8/10

(54) **Optoelektronischer Sensor**
Optoelectronic sensor
Capteur optoélectronique

(30) Priorität: 06.07.2000 DE 10032840
(43) Veröffentlichungstag der Anmeldung: 09.01.2002
(73) Patentinhaber: SICK AG, 79183 Waldkirch, Breisgau (DE)
(72) Erfinder: Merettig, Gerhard, 79350 Sexau (DE)
(74) Vertreter: Manitz, Finsterwald & Partner GbR

(56) Entgegenhaltungen:
- DE-A- 2 340 978
- DE-A- 4 238 666
- DE-A- 19 530 601
- US-A- 4 247 765
- US-A- 5 091 640

## Beschreibung

Die Erfindung betrifft einen optoelektronischen Sensor, insbesondere Lichtschranke oder dergleichen, mit wenigstens einer ein optoelektronisches Sendeelement umfassenden Sendeeinheit, wenigstens einem optoelektronischen Anzeigeelement und wenigstens einer Versorgungsspannungsquelle.

Zu diesen optoelektronischen Sensoren zählen insbesondere Lichtschranken. Diese können beispielsweise als Autokollimations-Lichtschranken, Reflexions-Lichtschranken, Lichttaster, Abstandstaster, usw. ausgeführt sein.

Bei derartigen optoelektronischen Sensoren entsteht ein Großteil der Verlustleistung in der Sendestufe und der Anzeige. Hohe Sendepulsströme führen bei hohen Versorgungsspannungen zu einer entsprechend hohen Verlustleistung. Zur Reduzierung der Störabstrahlung sind entsprechend große Kondensatoren erforderlich.

Da sowohl der Anzeige- als auch der Sendestrom in der Regel unabhängig von der Spannungsversorgung sein sollen, steigt die Verlustleistung bei einer herkömmlichen Schaltung proportional zur Versorgungsspannung an.

Dokumente US 5,091,640, US 4,247,765 und DE 2 340 978 beschreiben ebenfalls optoelektronische Sensoren.

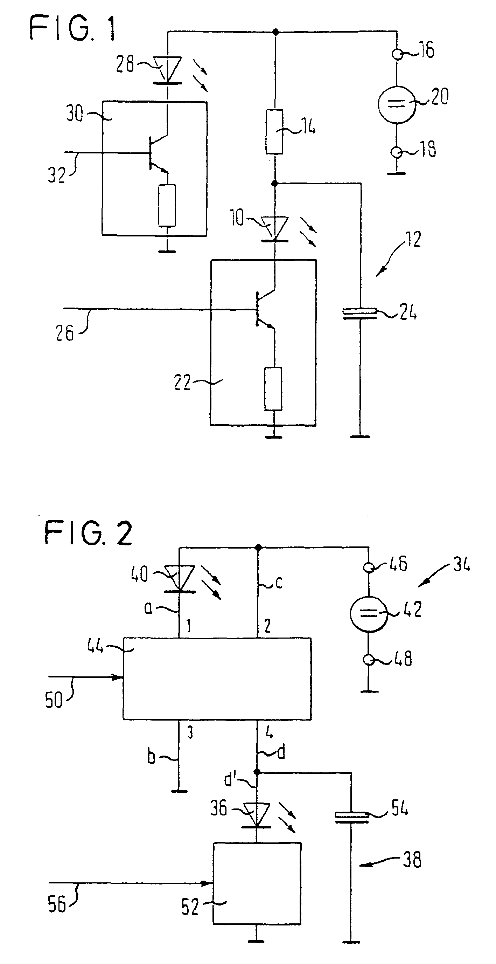

Fig. 1 zeigt eine die genannten Nachteile aufweisende herkömmliche Sendestufe eines herkömmlichen optoelektronischen Sensors. Dabei ist die ein optoelektronisches Sendeelement 10 umfassende Sendeeinheit 12 einerseits über einen Widerstand 14 an die eine, beispielsweise ein positives Potential aufweisende Klemme 16 und andererseits an die andere, beispielsweise Masse entsprechende Klemme 18 einer Versorgungsspannungsquelle 20 angeschlossen, bei der es sich im folgenden Fall um eine Gleichspannungsquelle handelt. Zum das Sendeelement 10 sowie einen dazu in Serie geschalteten Treiber 22 umfassenden Serienkreis ist ein Sendekondensator 24 parallelgeschaltet. Die Sendeeinheit 12 ist über eine zum Treiber 22 führende Steuerschaltung 26 ansteuerbar.

Zu dem die Sendeeinheit 12 und den Widerstand 14 enthaltenden Serienkreis ist ein weiterer, das Anzeigeelement 28 und einen weiteren Treiber 30 umfassender Serienkreis parallelgeschaltet. Auch dieser weitere Serienkreis 28, 30 ist wieder an die beiden Klemmen 16, 18 der Versorgungsspannungsquelle 20 angeschlossen. Das Anzeigeelement 28 wird über eine zum Treiber 30 führende Steuerleitung 32 angesteuert.

Ziel der Erfindung ist es, einen verbesserten optoelektronischen Sensor der eingangs genannten Art zu schaffen, bei dem die zuvor genannten Nachteile beseitigt sind. Dabei soll insbesondere auch die Verwendung deutlich kleinerer und preisgünstigerer Bauelemente ermöglicht werden. Gleichzeitig soll die Verlustleistung auf ein Minimum herabgesetzt und die Störabstrahlung über die Versorgungsleitung reduziert sein.

Diese Aufgabe wird durch die kennzeichnenden Merkmale des Anspruchs 1 gelöst.

Aufgrund dieser Ausbildung wird insbesondere eine Miniaturisierung, Verlustleistungsreduktion, Kostenminimierung und Performanceverbesserung erreicht. Es ist der Einsatz deutlich kleinerer und preisgünstigerer Bauelemente möglich, wobei gleichzeitig die Verlustleistung sowie die Störabstrahlung über die Versorgungsleitung auf ein Minimum herabgesetzt werden.

Bei einer bevorzugten praktischen Ausführungsform des erfindungsgemäßen optoelektronischen Sensors ist die Schaltungsanordnung durch einen Matrixschalter gebildet. Es wird also eine aktive Schaltmatrix eingesetzt, deren Schaltzustand sich in Abhängigkeit von der Ansteuerung des Anzeigeelements und von der Versorgungsspannungshöhe automatisch entsprechend ändert.

Die Sendeeinheit umfaßt zweckmäßigerweise einen mit dem Sendeelement in Serie geschalteten Treiber. Dabei ist der Sendekondensator vorzugsweise zu dem das Sendeelement und den Treiber enthaltenden Serienkreis parallelgeschaltet.

Die Verlustleistung kann beispielsweise dadurch weiter reduziert werden, daß über die Schaltungsanordnung bei über einem Grenzwert liegender Versorgungsspannung eine weitere Baugruppe wie insbesondere eine Auswerteschaltung (z.B. Verstärker, Signalaufbereitung, usw.) oder dergleichen mit dem Anzeigeelement und/oder der Sendeeinheit in Serie schaltbar ist. Bei einigen AC-Geräten wird zwar bereits eine Reihenschaltung von Anzeige und Restelektronik angewandt. Da es sich hierbei jedoch stets um höhere Spannungen (24-260 V-Wechselspannung) handelt, ist die zuvor beschriebene, erfindungsgemäße Umschaltung nicht erforderlich. Mit der erfindungsgemäßen Umschaltung ist nicht nur beispielsweise eine Halbierung der Verluste bei Überschreiten einer festgelegten Spannung möglich, es ist zusätzlich auch das Erreichen der Funktionsdaten bei kleineren Spannungen gesichert.

Zur Herstellung der jeweiligen Verbindungen kann die Schaltungsanordnung vorteilhafterweise wenigstens eine schaltbare Stromquelle und/oder wenigstens ein eirien definierten Einschaltwiderstand besitzendes Schaltelement umfassen.

Mit der Ausführung der durch die Schaltungsanordnung bewirkten Verbindungen als geschaltete Stromquellen oder als Schalter mit definiertem Einschaltwiderstand werden Störrückwirkungen beispielsweise des Senders auf die Versorgung vermieden bzw. eine konstante Anzeigenhelligkeit gewährleistet.

Zu den Vorteilen einer Stromquelle gegenüber einem üblichen Vorwiderstand zählen:
- der reduzierte Stromripple, wodurch sichergetellt ist, daß der insbesondere bei Tantalkondensatoren kritische Stromwert nicht erreicht wird, und
- die auch im Einfehlerfall vorhandene Begrenzung der Strahlleistung der Sendediode.

Von Vorteil ist auch, wenn die Schaltungsanordnung mit einer Spannungsbegrenzung versehen ist. Diese ist vorzugsweise vorgesehen, um die Spannung an wenigstens einer an die Schaltungsanordnung angeschlossenen Baugruppe zu begrenzen. So kann sie beispielsweise der Begrenzung der an der Sendeeinheit anliegenden Spannung dienen.

Die jeweilige Spannungsbegrenzung kann beispielsweise eine Regelschaltung umfassen. Über eine solche Regelschaltung kann beispielsweise eine Stromquelle so angesteuert werden, daß zumindest zu Beginn einer jeweiligen Ansteuerung der Sendeeinheit am Sendekondensator eine vorgebbare Spannung anliegt.

Eine jeweilige Spannungsbegrenzung kann beispielsweise auch so ausgeführt sein, daß die Verbindung zwischen einer jeweiligen Baugruppe und der Versorgungsspannungsquelle unterbrochen wird, sobald die an der Baugruppe anliegende Spannung einen definierten, vorzugsweise einstellbaren Wert überschreitet.

Mit den zuvor angegebenen möglichen Ausführungen einer jeweiligen Spannungsbegrenzung können deutlich kleinere, preisgünstigere Kondensatoren und Treibertransistoren eingesetzt werden.

Wesentliche Vorteile werden somit insbesondere durch die folgenden, einzeln oder in beliebiger Kombination miteinander anwendbaren erfindungsgemäßen Maßnahmen erreicht:
- eine mehrfache Verwendung von Strömen durch eine entsprechende Reihenschaltung
- Begrenzung der Spannung an Baugruppen
- Strombegrenzung zur Erreichung der Einfehlerbedingung.

Die Erfindung wird im folgenden anhand eines Ausführungsbeispiels unter Bezugnahme auf die Zeichnung näher erläutert; in dieser zeigen:
- Fig. 1: eine schematische Darstellung einer herkömmlichen Sendestufe eines herkömmlichen optoelektronischen Sensors und
- Fig. 2: eine schematische Darstellung einer Ausführungsform der Sendestufe mit zugeordneter Anzeige des erfindungsgemäßen optoelektronischen Sensors.

Fig. 2 zeigt in schematischer Teildarstellung eine rein beispielhafte Ausführungsform eines erfindungsgemäßen optoelektronischen Sensors 34, bei dem es sich insbesondere um eine Lichtschranke oder dergleichen handeln kann.

Gemäß Fig. 2 umfaßt dieser optoelektronische Sensor 34 wenigstens eine ein optoelektronisches Sendeelement 36 umfassende Sendeeinheit 38, wenigstens ein optoelektronisches Anzeigeelement 40 und wenigstens eine Versorgungsspannungsquelle 42, hier eine Gleichspannungsquelle.

Es ist eine in Abhängigkeit von der Ansteuerung des Anzeigeelements 40 und von der Versorgungsspannungshöhe ansteuerbare, vorzugsweise als aktive Schaltmatrix oder aktiver Matrixschalter 44 ausgeführte Schaltungsanordnung vorgesehen. Der Schaltzustand des aktiven Matrixschalters 44 ändert sich in Abhängigkeit von der Ansteuerung des Anzeigeelements 40 und von der Versorgungsspannungshöhe automatisch so, daß über diesen Matrixschalter 44 bei angesteuertem Anzeigeelement 40 die Sendeeinheit 38 und das Anzeigeelement 40 im Fall einer über einem Grenzwert liegenden Versorgungsspannung 42 in Serie geschaltet und im Fall einer unter dem Grenzwert liegenden oder diesem entsprechenden Versorgungsspannung 42 zwei zueinander parallelen Stromkreisen a, b; c, d zugeschaltet werden. Dabei liegt die Versorgungsspannung 42 im einen Fall am Serienkreis a, d und im anderen Fall an den beiden zueinander parallelen Stromkreisen a, b; c, d an. Dagegen wird bei nicht angesteuertem Anzeigeelement 40 die Sendeeinheit 38 über den Matrixschalter 44 getrennt vom Anzeigeelement 40 mit der Versorgungsspannung 42 verbunden.

Dazu besitzt der Matrixschalter 44 im vorliegenden Fall vier Pins, die intern entsprechend miteinander verbunden bzw. voneinander getrennt werden. Das beispielsweise durch eine Leuchtdiode gebildete Sendeelement 40 ist zwischen die eine, beispielsweise ein positives Potential besitzende Klemme 46 der Versorgungsspannungsquelle 42 und den Pin 1 des Matrixschalters 44 geschaltet. Der Pin 2 des Matrixschalters 44 ist durch den Strompfad c direkt an die Klemme 46 der Versorgungsspannungsquelle 42 angeschlossen.

Die andere Klemme 48 der Versorgungsspannungsquelle 42 liegt im vorliegenden Fall an Masse.

Der Pin 3 der Schaltmatrix 44 liegt über den Strompfad b an Masse. Der Pin 4 des Matrixschalters 44 ist mit dem die Sendeeinheit 38 umfassenden, am anderen Ende wieder an Masse liegenden Strompfad d verbunden.

Die Anzeige 40 ist über eine zum Matrixschalter 44 führende Steuerleitung 50 ansteuerbar.

Die Sendeeinheit 38 umfaßt einen mit dem Sendeelement 32 in Serie geschalteten Treiber 52 sowie einen Sendekondensator 54, der zum das Sendeelement 36 und den Treiber 52 enthaltenden Serienkreis d' parallelgeschaltet ist. Der dem Sendeelement 36 zugeordnete Treiber 52 ist über eine Steuerleitung 56 ansteuerbar.

Mit dem aktiven Matrixschalter 44 ergibt sich somit die folgende Verbindungsmatrix:

| | niedrige Versorgungsspannung | höhere Versorgungsspannung |
|---|---|---|
| Anzeige aus | Verbindung zwischen: Pin2 und Pin4 | Verbindung zwischen: Pin2 und Pin4 |
| Anzeige an | Verbindung zwischen: Pin2 und Pin4 Pin1 und Pin3 | Verbindung zwischen: Pin1 und Pin4 |

Der Grenzwert kann einstellbar sein.

Zur Herstellung der jeweiligen Verbindungen kann der Matrixschalter 44 beispielsweise wenigstens eine schaltbare Stromquelle und/oder wenigstens ein einen definierten Einschaltwiderstand besitzendes Schalterelement umfassen.

Alternativ oder zusätzlich kann der Matrixschalter mit einer Spannungsbegrenzung versehen sein. Dabei kann die Spannung an wenigstens einer an den Matrixschalter 44 angeschlossenen Baugruppe begrenzt werden. So kann beispielsweise eine entsprechende Spannungsbegrenzung für die an der Sendeeinheit 38 anliegende Spannung vorgesehen sein.

Die jeweilige Spannungsbegrenzung kann beispielsweise eine Regelschaltung umfassen, über die vorzugsweise eine Stromquelle so ansteuerbar ist, daß zumindest zu Beginn einer jeweiligen Ansteuerung der Sendeeinheit 38 am Sendekondensator 54 eine vorgebbare Spannung anliegt.

Die jeweilige Spannungsbegrenzung kann beispielsweise auch so ausgeführt sein, daß die Verbindung zwischen der betreffenden Baugruppe, beispielsweise der Sendeeinheit 38, und der Versorgungsspannungsquelle 42 unterbrochen wird, sobald die an der Baugruppe anliegende Spannung einen definierten, vorzugsweise einstellbaren Wert überschreitet.

### Bezugszeichenliste

- 10: optoelektronisches Sendeelement
- 12: Sendeeinheit
- 14: Widerstand
- 16: Klemme
- 18: Klemme
- 20: Versorgungsspannungsquelle
- 22: Treiber
- 24: Sendekondensator
- 26: Steuerleitung
- 28: Anzeigeelement
- 30: Treiber
- 32: Steuerleitung
- 34: optoelektronischer Sensor
- 36: optoelektronisches Sendeelement
- 38: Sendeeinheit
- 40: optoelektronisches Anzeigeelement
- 42: Versorgungsspannung, Versorgungsspannungsquelle
- 44: Schaltungsanordnung, Matrixschalter
- 46: Klemme
- 48: Klemme
- 50: Steuerleitung
- 52: Treiber
- 54: Sendekondensator
- 56: Steuerleitung
- a, b, c, d: Strompfade
- d': Serienkreis

## Patentansprüche

1. Optoelektronischer Sensor (34), insbesondere Lichtschranke oder dergleichen, mit wenigstens einer ein optoelektronisches Sendeelement (36) umfassenden Sendeeinheit (38), wenigstens einem optoelektronischen Anzeigeelement (40) und wenigstens einer Versorgungsspannungsquelle (42),
**dadurch gekennzeichnet,**
**daß** eine in Abhängigkeit von der Ansteuerung des Anzeigeelements (40) und von der Versorgungsspannungshöhe ansteuerbare Schaltungsanordnung (44) vorgesehen ist, über die bei angesteuertem Anzeigeelement (40) die Sendeeinheit (38) und das Anzeigeelement (40) im Fall einer über einem Grenzwert liegenden Versorgungsspannung (42) in Serie schaltbar und im Fall einer unter dem Grenzwert liegenden oder diesem entsprechenden Versorgungsspannung (42) zwei zueinander parallelen Stromkreisen (a, b; c, d) zuschaltbar sind, wobei die Versorgungsspannung im einen Fall am Serienkreis (a, d) und im andern Fall an den beiden zueinander parallelen Stromkreisen (a, b; c, d) anliegt, und über die bei nicht angesteuertem Anzeigeelement (40) die Sendeeinheit (38) getrennt vom Anzeigeelement (40) mit der Versorgungsspannung (42) verbindbar ist.

2. Sensor nach Anspruch 1,
**dadurch gekennzeichnet,**
**daß** die Schaltungsanordnung durch einen Matrixschalter (44) gebildet ist.

3. Sensor nach einem der vorhergehenden Ansprüche,
**dadurch gekennzeichnet,**
**daß** die Sendeeinheit (38) einen Sendekondensator (54) umfaßt, der zu einem das Sendeelement (36) enthaltenden Stromkreis (d') parallel geschaltet ist.

4. Sensor nach einem der vorhergehenden Ansprüche,
**dadurch gekennzeichnet,**
**daß** die Sendeeinheit (38) einen mit dem Sendeelement (32) in Serie geschalteten Treiber (52) umfaßt.

5. Sensor nach Anspruch 3 und 4,
**dadurch gekennzeichnet,**
**daß** der Sendekondensator (54) zu dem das Sendeelement (36) und den Treiber (52) enthaltenden Serienkreis (d') parallel geschaltet ist.

6. Sensor nach einem der vorhergehenden Ansprüchen,
**dadurch gekennzeichnet,**
**daß** über die Schaltungsanordnung (44) bei über einem Grenzwert liegender Versorgungsspannung (42) eine weitere Baugruppe wie insbesondere eine Auswerteschaltung oder dergleichen mit dem Anzeigeelement (40) und/oder der Sendeeinheit (38) in Serie schaltbar ist.

7. Sensor nach einem der vorhergehenden Ansprüche,
**dadurch gekennzeichnet,**
**daß** der Grenzwert einstellbar ist.

8. Sensor nach einem der vorhergehenden Ansprüchen,
**dadurch gekennzeichnet,**
**daß** die Schaltungsanordnung (44) zur Herstellung der jeweiligen Verbindungen wenigstens eine schaltbare Stromquelle umfaßt.

9. Sensor nach einem der vorhergehenden Ansprüchen,
**dadurch gekennzeichnet,**
**daß** die Schaltungsanordnung (44) zur Herstellung der jeweiligen Verbindungen wenigstens ein einen definierten Einschaltwiderstand besitzendes Schalterelement umfaßt.

10. Sensor nach einem der vorhergehenden Ansprüchen,
**dadurch gekennzeichnet,**
**daß** die Schaltungsanordnung (44) mit einer Spannungsbegrenzung versehen ist.

11. Sensor nach Anspruch 10,
**dadurch gekennzeichnet,**
**daß** die Spannungsbegrenzung vorgesehen ist, um die Spannung an wenigstens einer an die Schaltungsanordnung (44) angeschlossenen Baugruppe (38) zu begrenzen.

12. Sensor nach Anspruche 11,
**dadurch gekennzeichnet,**
**daß** zumindest zur Begrenzung der an der Sendeeinheit (38) anliegenden Spannung eine entsprechende Spannungsbegrenzung vorgesehen ist.

13. Sensor nach Anspruch 12,
**dadurch gekennzeichnet,**
**daß** die Spannungsbegrenzung eine Regelschaltung umfaßt, über die vorzugsweise eine Stromquelle so ansteuerbar ist, daß zumindest zu Beginn einer jeweiligen Ansteuerung der Sendeeinheit (38) am Sendekondensator (54) eine vorgebbare Spannung anliegt.

14. Sensor nach einem der vorhergehenden Ansprüche,
**dadurch gekennzeichnet,**
**daß** die Spannungsbegrenzung so ausgeführt ist, daß die Verbindung zwischen einer jeweiligen Baugruppe (38) und der Versorgungsspannungsquelle (42) unterbrochen wird, sobald die an der Baugruppe (38) anliegende Spannung einen definierten, vorzugsweise einstellbaren Wert überschreitet.

## Claims

1. An optoelectronic sensor (34), in particular a light barrier or the like, comprising at least one transmitter unit (38) including an optoelectronic transmitter element (36), at least one optoelectronic display element (40) and at least one supply voltage source (42), **characterised in that** a circuit arrangement (44) is provided which can be controlled in dependence on the control of the display element (40) and on the supply voltage level and via which, when the display element (40) is controlled, the transmitter unit (38) and the display element (40) can be switched in series in the case of a supply voltage (42) lying above a limit value and two circuits (a, b; c, d) parallel to one another can be switched in in the case of a supply voltage (42) lying below the limit value or corresponding to it, with the supply voltage being applied to the series circuit (a, d) in the one case and to the two circuits (a, b; c, d) parallel to one another in the other case, and via which, when the display element (40) is not controlled, the transmitter unit (38) can be connected to the supply voltage (42) separately from the display unit (40).

2. A sensor in accordance with claim 1, **characterised in that** the circuit arrangement is formed by a matrix switch (44).

3. A sensor in accordance with any one of the preceding claims, **characterised in that** the transmitter unit (38) includes a transmitter capacitor (54) which is connected in parallel to a circuit (d') including the transmitter element (36).

4. A sensor in accordance with any one of the preceding claims, **characterised in that** the transmitter unit (38) includes a driver (52) connected in series to the transmitter element (32).

5. A sensor in accordance with claim 3 and claim 4, **characterised in that** the transmitter capacitor (54) is connected in parallel to the series circuit (d') including the transmitter element (36) and the driver (52).

6. A sensor in accordance with any one of the preceding claims, **characterised in that**, when the supply voltage (42) lies above a limit value, a further component group such as in particular an evaluation circuit or the like can be connected in series to the display element (40) and/ or to the transmitter unit (38) via the circuit arrangement (44).

7. A sensor in accordance with any one of the preceding claims, **characterised in that** the limit value is adjustable.

8. A sensor in accordance with any one of the preceding claims, **characterised in that** the circuit arrangement (44) includes at least one switchable current source for the establishing of the respective connections.

9. A sensor in accordance with any one of the preceding claims, **characterised in that** the circuit arrangement (44) includes at least one switch element having a defined on resistance for the establishing of the respective connections.

10. A sensor in accordance with any one of the preceding claims, **characterised in that** the circuit arrangement (44) is provided with a voltage limiter.

11. A sensor in accordance with claim 10, **characterised in that** the voltage limiter is provided to limit the voltage at at least one component group (38) connected to the circuit arrangement (44).

12. A sensor in accordance with claim 11, **characterised in that** a corresponding voltage limiter is provided at least for the limitation of the voltage applied to the transmitter unit (38).

13. A sensor in accordance with claim 12, **characterised in that** the voltage limiter includes a control circuit via which a current source can preferably be controlled such that a pre-settable voltage is applied to the transmitter capacitor (54) at least at the start of a respective control of the transmitter unit (38).

14. A sensor in accordance with any one of the preceding claims, **characterised in that** the voltage limiter is designed such that the connection between a respective component group (38) and the supply voltage source (42) is interrupted as soon as the voltage applied to the component group (38) exceeds a defined value, preferably an adjustable value.

## Revendications

1. Capteur optoélectronique (34), en particulier barrière lumineuse ou similaire, comportant au moins une unité émettrice (38) comprenant un élément émetteur (36) optoélectronique, au moins un élément d'affichage (40) optoélectronique et au moins une source de tension d'alimentation (42),
**caractérisé en ce qu'**il est prévu un agencement de circuit (44) susceptible d'être piloté en fonction du pilotage de l'élément d'affichage (40) et de la hauteur la tension d'alimentation, via lequel, lorsque l'élément d'affichage (40) est piloté, l'unité émettrice (38) et l'élément d'affichage (40) peuvent être branchés en série dans le cas où la tension d'alimentation (42) dépasse une valeur limite et peuvent être branchés à deux circuits de courant (a, b ; c, d) parallèles l'un à l'autre dans le cas où la tension d'alimentation (42) est inférieure à la valeur limite ou correspond à celle-ci, la tension d'alimentation étant appliquée, dans un cas, au circuit en série (a, d), et dans l'autre cas, aux deux circuits de courant (a, b ; c, d) parallèles l'un à l'autre, et via lesquels, lorsque l'élément d'affichage (40) n'est pas piloté, l'unité émettrice (38) peut être reliée à la tension d'alimentation (42), séparément de l'élément d'affichage (40).

2. Capteur selon la revendication 1,
**caractérisé en ce que** l'agencement de circuit est formé par un commutateur matriciel (44).

3. Capteur selon l'une des revendications précédentes,
**caractérisé en ce que** l'unité émettrice (38) comprend un condensateur émetteur (54) qui est branché en parallèle à un circuit de courant (d') contenant l'élément émetteur (36).

4. Capteur selon l'une des revendications précédentes,
**caractérisé en ce que** l'unité émettrice (38) comprend un pilote (52) branché en série avec l'élément émetteur (32).

5. Capteur selon la revendication 3 et 4,
**caractérisé en ce que** le condensateur émetteur (54) est branché en parallèle au circuit en série (d') contenant l'élément émetteur (36) et le pilote (52).

6. Capteur selon l'une des revendications précédentes,
**caractérisé en ce que** via l'agencement de circuit (44), au cas où la tension d'alimentation (42) dépasse une valeur limite, on peut brancher en série un autre sous-ensemble tel que par exemple un circuit d'évaluation ou similaire, avec l'élément d'affichage (40) et/ou l'unité émettrice (38).

7. Capteur selon l'une des revendications précédentes,
**caractérisé en ce que** la valeur limite est réglable.

8. Capteur selon l'une des revendications précédentes,
**caractérisé en ce que** l'agencement de circuit (44) comprend au moins une source de courant commutable pour établir les liaisons respectives.

9. Capteur selon l'une des revendications précédentes,
**caractérisé en ce que** l'agencement de circuit (44) comprend au moins un élément de commutateur possédant une résistance de mise en circuit définie pour établir les liaisons respectives.

10. Capteur selon l'une des revendications précédentes,
**caractérisé en ce que** l'agencement de circuit (44) est pourvu d'un limiteur de tension.

11. Capteur selon la revendication 10,
**caractérisé en ce que** la limitation de tension est prévue pour limiter la tension sur au moins un sous-ensemble (38) branché à l'agencement de circuit (44).

12. Capteur selon la revendication 11,
**caractérisé en ce qu'**au moins pour limiter la tension appliquée à l'unité émettrice (38), il est prévu une limitation de tension correspondante.

13. Capteur selon la revendication 12,
**caractérisé en ce que** la limitation de tension comprend un circuit de réglage via lequel on peut piloter de préférence une source de courant de telle sorte qu'au moins au début d'un pilotage respectif de l'unité émettrice (38), une tension prédéterminable est appliquée au condensateur émetteur (54).

14. Capteur selon l'une des revendications précédentes,
**caractérisé en ce que** la limitation de tension est réalisée telle que la liaison entre un sous-ensemble (38) respectif et la source de tension d'alimentation (42) est interrompue dès que la tension appliquée au sous-ensemble (3 8) dépasse une valeur définie, de préférence réglable.
